# FASCICULE DE BREVET EUROPEEN

(11) **EP 0 750 346 B1**
(45) Date de publication et mention de la délivrance du brevet: **23.08.2000**
(21) Numéro de dépôt: 96410074.7
(22) Date de dépôt: 18.06.1996
(51) Int. Cl.: H01L 27/08

(54) **Assemblage monolithique de composants semi-conducteurs incluant une diode rapide**
Monolytische Montage von Halbleiterbauteilen mit einer Hochgeschwindigkeitsdiode
Monolithic assembly of semiconductor components including a high-speed diode

(30) Priorité: 22.06.1995 FR 9507737
(43) Date de publication de la demande: 27.12.1996
(73) Titulaire: STMicroelectronics S.A., 94250 Gentilly (FR)
(72) Inventeur: Lhorte, André, 37550 Saint Avertin (FR)
(74) Mandataire: de Beaumont, Michel

(56) Documents cités:
- EP-A- 0 143 259
- EP-A- 0 635 886
- PATENT ABSTRACTS OF JAPAN vol. 005, no. 091 (E-061), 13 Juin 1981 & JP-A-56 035473 (NIPPON TELEGR & TELEPH CORP), 8 Avril 1981,
- PATENT ABSTRACTS OF JAPAN vol. 010, no. 069 (E-389), 18 Mars 1986 & JP-A-60 219776 (MITSUBISHI DENKI KK), 2 Novembre 1985,
- PATENT ABSTRACTS OF JAPAN vol. 012, no. 024 (E-576), 23 Janvier 1988 & JP-A-62 179756 (SANYO ELECTRIC CO LTD;OTHERS: 01), 6 Août 1987,

## Description

La présente invention concerne des assemblages monolithiques de composants semiconducteurs incluant au moins une diode rapide verticale et au moins un autre composant de type vertical ayant avec la diode verticale une borne commune correspondant à une métallisation uniforme destinée à être brasée sur un support.

La présente invention vise en particulier le cas où cet autre composant est une diode et où l'on cherche à réaliser dans un même composant monolithique des diodes de rapidités distinctes.

Par exemple, on trouve souvent, comme le représentent les figures 1 et 2, des assemblages de deux diodes D1 et D2 en série, les bornes extrêmes A et B et la borne médiane C devant être accessibles. Ces diodes ont des fonctions distinctes. Dans le cas de circuits de balayage de télévision, illustré en figure 2, la diode D1 doit être une diode rapide (de modulation) et la diode D2 a une fonction d'amortissement (damper). Cette diode D2 doit présenter de façon classique une faible chute de tension en direct, une faible surtension à la mise en conduction et un courant inverse pratiquement nul. On souhaite que les deux diodes soient réalisées dans un composant monolithique et que la borne commune C corresponde à une métallisation de face arrière de sorte que les diodes puissent être montées sur un support dissipateur thermique pour éviter tout échauffement.

Classiquement, les deux diodes D1 et D2 sont réalisées selon des structures de type PIN classiques et présentent les avantages et les inconvénients liés à leur nature même. Elles présentent un faible courant de fuite en inverse et des chutes de tension en direct qui varient entre 0,8 et 1,5 volt selon la densité de courant qui les traverse. Ainsi, les diodes PIN conviennent bien pour la réalisation de diodes telles que la diode D2. Pour obtenir des diodes très rapides, ce qui correspond aux exigences demandées pour la diode D1, et éventuellement dans une moindre mesure pour la diode D2, il est nécessaire de créer des défauts dans le substrat, par exemple par diffusion d'impuretés métalliques telles que de l'or ou du platine ou par irradiation électronique ou de particules lourdes.

Cette dernière caractéristique, à savoir la nécessité de création de défauts, rend ces structures difficilement compatibles avec leur réalisation sur une même puce de circuit intégré que d'autres éléments qui ne doivent pas subir de tels traitements. En particulier, quand on utilise, pour augmenter la rapidité d'une diode, une diffusion d'or, il est pratiquement impossible de limiter l'étendue de la diffusion de l'or étant donné la grande vitesse de diffusion de ce métal.

On a recherché dans l'art antérieur divers compromis pour obtenir de façon idéale des diodes de rapidités différentes mais, quand les exigences deviennent trop strictes, on est amené à utiliser des diodes discrètes séparées. En effet, si pour rendre une diode rapide, on veut utiliser une diffusion d'or ou de platine, cette diffusion s'étendra sur tout le composant et les deux diodes auront finalement la même rapidité. Il est également difficile de délimiter une zone soumise à une irradiation.

Autre types de composants semiconducteur sont décrits dans JP56035473 et JP62179756.

Ainsi, un objet de la présente invention est de prévoir une nouvelle structure monolithique assemblant une diode rapide verticale et d'autres éléments semiconducteurs verticaux, par exemple une diode d'amortissement.

Un autre objet de la présente invention est de prévoir un tel assemblage dans laquelle la diode rapide et l'autre élément semiconducteur présentent une électrode commune correspondant à la face arrière du composant semiconducteur pouvant être brasée sur un support.

Ainsi, la présente invention telle que revendiquée dans la revendication 1 prévoit un assemblage monolithique d'une diode rapide verticale et d'au moins un autre composant vertical, dans lequel la diode rapide est constituée d'un substrat de type N dans l'une des faces duquel est formée une région continue de type N⁺ et dans l'autre face duquel est formée une région discontinue de type P⁺, la face arrière de l'assemblage étant revêtue d'une métallisation unique.

Selon un mode de réalisation de la présente invention, quand la région de type P⁺ discontinue de la diode rapide se trouve du côté de la face arrière de l'assemblage, cette diode rapide est entourée d'un mur d'isolement.

Selon un mode de réalisation de la présente invention, l'autre composant vertical est une diode à jonction.

Selon un mode de réalisation de la présente invention, l'autre composant vertical est une diode de même type que la première mais de caractéristiques différentes. Par exemple, les régions discontinues de type P⁺ des deux diodes ont des proportions différentes.

Selon un mode de réalisation de la présente invention, l'assemblage monolithique résulte en outre d'un traitement de réduction de durée de vie des porteurs tel qu'irradiation ou diffusion d'impuretés métalliques.

Ces objets, caractéristiques, avantages ainsi que d'autres de la présente invention seront exposés en détail dans la description suivante de modes de réalisation particuliers faite, à titre non-limitatif, en relation avec les figures jointes parmi lesquelles :
les figures 1 et 2 représentent des assemblages de diodes que la présente invention vise à réaliser ;
la figure 3 est une vue en coupe d'un premier exemple, correspondant à la figure 1, d'assemblage selon la présente invention d'une diode rapide avec une autre diode en un composant unique ;
la figure 4 est une vue en coupe d'un autre exemple, correspondant à la figure 2, d'assemblage selon la présente invention d'une diode rapide avec une autre diode en un composant unique ; et
la figure 5 est une vue en coupe d'encore un autre exemple d'assemblage d'une diode rapide avec une autre diode.

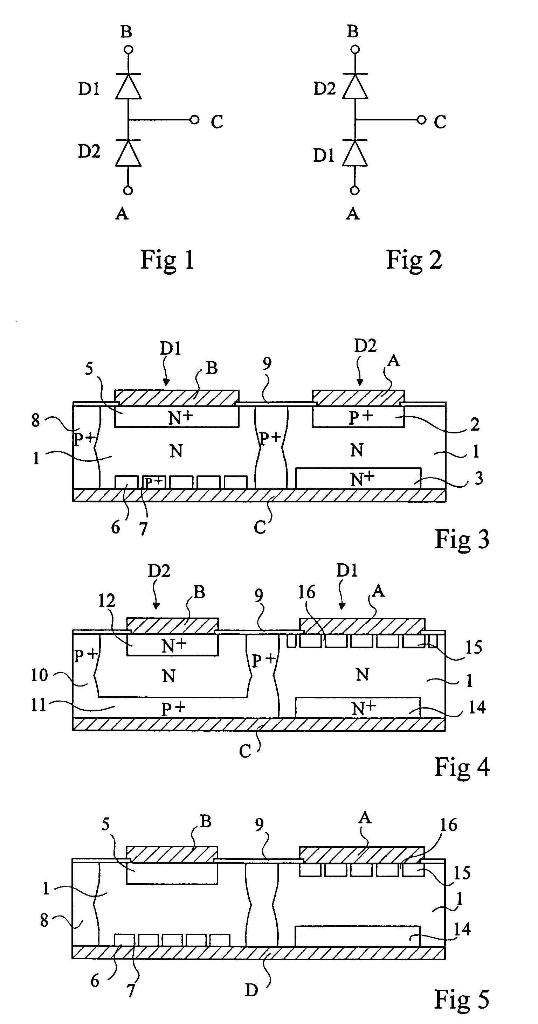

La figure 3 représente un assemblage de deux diodes D1 et D2, conforme à la figure 1, la diode D1 étant une diode rapide et étant connectée par son anode à la cathode de la diode D2. L'ensemble est réalisé sur un substrat 1 de type N. La diode D2 est une diode PIN classique qui comprend du côté de la face supérieure une région 2 de type P et du côté de la face inférieure une région 3 de type N fortement dopée. Dans la partie gauche de la figure, on retrouve une diode combinant un contact Schottky et une jonction PN. De telles diodes ont été décrites par B.J. Baliga (IEEE Electron Device Letters, vol. EDL-5, N° 6, juin 1984). Elles présentent à la fois un faible courant de fuite en inverse et une plus faible chute de tension en direct que des diodes PIN habituelles. Cette diode comprend du côté de la face supérieure du substrat une région de cathode 5 de type N⁺ et du côté de la face inférieure du substrat une région 6 de type P⁺ entrecoupée d'ouvertures 7. La périphérie de cette diode, au moins le long de la périphérie du composant, est cernée d'une région de type P fortement dopée 8, formée par exemple par diffusion profonde à partir des faces inférieure et supérieure du substrat. La face arrière du composant est revêtue d'une métallisation C qui constitue l'anode de la diode D1 et la cathode de la diode D2. Cette métallisation forme un contact ohmique avec la région 6 et un contact Schottky avec les portions du substrat N apparaissant dans les ouvertures 7. La région 2 est revêtue d'une métallisation A et la région 5 est revêtue d'une métallisation B. Ces métallisations A, B, C correspondent respectivement aux bornes A, B, C de la figure 1. La face supérieure du composant, en dehors des régions où elle est en contact avec les métallisations A et B est revêtue d'une couche isolante 9, couramment une couche d'oxyde de silicium.

A titre d'exemple de métallisation permettant un contact Schottky, on pourra choisir de l'aluminium ou un siliciure, par exemple de platine, de nickel, de molybdène ou d'un mélange de ces métaux ou d'autres métaux assurant la même fonction. Pour un contact de face avant, le siliciure pourra être revêtu d'une couche servant de barrière de diffusion telle que TiW ou TiN et d'aluminium. Pour un contact de face arrière, la couche finale doit pouvoir être brasée et sera par exemple en NiAu ou NiAg. Si la couche initiale est un siliciure, on pourra prévoir une couche intermédiaire servant de barrière de diffusion.

On notera que cette structure peut être brasée par la métallisation inférieure C sur un support. En effet, même s'il se produit des débordements de la brasure sur les parties latérales du composant, ceux-ci ne provoqueront pas de court-circuit en raison de la présence du mur d'isolement 8 de type P.

La figure 4 représente une structure mettant en oeuvre le circuit de la figure 2. La diode D2 est cette fois-ci réalisée dans un caisson entouré d'un mur d'isolement 10 de type P ramenant la terminaison de la jonction sur la face supérieure de la puce. Sa face arrière est revêtue d'une région 11 de type P et sa face supérieure comporte une région 12 de type N revêtue d'une métallisation B. La diode D1 est symétrique de la diode illustrée en figure 3 et comprend du côté de la face inférieure une région 14 de type N⁺ et du côté de la face supérieure une région 15 de type P interrompue d'ouvertures 16 revêtue d'une métallisation A. La face arrière est revêtue d'une métallisation uniforme C. A nouveau, en raison de la présence de mur d'isolement 10, cette structure peut sans risque être brasée sur un support.

La figure 5 représente une structure assemblant deux diodes de type Schottky/bipolaire. La partie gauche de la figure 5 correspond à la partie gauche de la figure 3 et la partie droite de la figure 5 à la partie droite de la figure 4. Un choix approprié du dessin et de la structure de chacune des diodes permet de leur conférer des caractéristiques différentes. En effet, une augmentation de la surface présentant un contact Schottky (à surface totale constante) ou une conception des zones diffusées minimisant leur injection permet d'augmenter la rapidité de la diode.

Dans ce qui précède, on a indiqué comment le choix de deux diodes dont l'une au moins est de type Schottky/bipolaire permet d'obtenir des diodes de rapidités distinctes. On pourra en plus procéder à une création de défauts (diffusion métallique ou irradiation) qui permettra de façon générale d'augmenter la rapidité des deux diodes tout en maintenant une différence de rapidité entre elles.

Ainsi, l'aspect fondamental de la présente invention réside dans l'assemblage de composants verticaux dont l'un est une diode de type bipolaire/Schottky, l'une au moins des structures verticales étant entourée d'un mur d'isolement pour permettre le brasage par la face arrière du composant. Le composant vertical autre que la diode rapide de type Schottky/bipolaire pourra être tout composant vertical choisi, par exemple un thyristor.

## Revendications

1. Assemblage monolithique dans un substrat (1) de type N d'une diode rapide verticale destinée à un fonctionnement en direct et d'au moins un autre composant vertical séparé de la diode par un mur d'isolement (8), dans lequel la diode rapide est de type Schottky-bipolaire et est constituée entre une première métallisation sur une première face du substrat en contact avec le substrat et avec une région discontinue (6, 15) de type P⁺ et une deuxième métallisation sur la deuxième face du substrat en contact avec une région continue (5 ; 14) de type N⁺, l'une des première et deuxième métallisations s'étendant sur toute une face du substrat et constituant aussi une métallisation dudit au moins un autre composant vertical.

2. Assemblage monolithique selon la revendication 1, caractérisé en ce que, quand la région de type P⁺ discontinue de la diode rapide se trouve du côté de la face arrière de l'assemblage, cette diode rapide est entourée d'un mur d'isolement (8).

3. Assemblage monolithique selon la revendication 1, caractérisé en ce que l'autre composant vertical est une diode à jonction.

4. Assemblage monolithique selon la revendication 1, caractérisé en ce que l'autre composant vertical est une diode de même type que la première mais de caractéristiques différentes.

5. Assemblage monolithique selon la revendication 4, caractérisé en ce que les régions discontinues (6, 15) de type P⁺ des deux diodes ont des proportions différentes.

6. Assemblage monolithique selon l'une quelconque des revendications 1 à 5, caractérisé en ce qu'il a été soumis à un traitement de réduction de durée de vie des porteurs tel qu'irradiation ou diffusion d'impuretés métalliques.

## Patentansprüche

1. Monolithische(s) Aggregat bzw. Baugruppe in einem Substrat (1) vom N-Typ, aus einer zum Betrieb in Durchlaßrichtung bestimmten vertikalen schnellen Diode und wenigstens einem anderen von der Diode durch eine Isolationswandung (8) getrennten vertikalen Bauteil, wobei die schnelle Diode vom Schottky-Bipolar-Typ ist und sich zwischen einer ersten Metallisierung auf einer ersten Seite des Substrats, die mit dem Substrat und mit einem diskontinuierlichen Bereich (6, 15) vom P⁺-Typ in Kontakt steht, einerseits und einer zweiten Metallisierung auf der zweiten Seite des Substrats in Kontakt mit einem kontinuierlichen Bereich (5; 14) vom N⁺-Typ andererseits erstreckt, und wobei von der genannten ersten und zweiten Metallisierung eine sich über eine ganze Seite bzw. Hauptfläche des Substrats erstreckt und auch eine Metallisierung des genannten wenigstens einen anderen vertikalen Bauteils bildet.

2. Monolithische(s) Aggregat bzw. Baugruppe nach Anspruch 1,
dadurch gekennzeichnet, daß, falls der diskontinuierliche P⁺-Bereich der schnellen Diode sich an der Rück- bzw. Unterseite des Aggregats bzw. der Baugruppe befindet, diese schnelle Diode von einer Isolationswandung (8) umgeben ist.

3. Monolithische(s) Aggregat bzw. Baugruppe nach Anspruch 1,
dadurch gekennzeichnet, daß das andere vertikale Bauteil eine Flächendiode ist.

4. Monolithische(s) Aggregat bzw. Baugruppe nach Anspruch 1,
dadurch gekennzeichnet, daß das andere vertikale Bauteil eine Diode desselben Typs wie die erste Diode, jedoch mit unterschiedlichen Eigenschaften, ist.

5. Monolithische(s) Aggregat bzw. Baugruppe nach Anspruch 4,
dadurch gekennzeichnet, daß die diskontinuierlichen Bereiche (6, 15) vom P⁺-Typ der beiden Dioden unterschiedliche Proportionen besitzen.

6. Monolithische(s) Aggregat bzw. Baugruppe nach einem der Ansprüche 1 bis 5,
dadurch gekennzeichnet, daß das Aggregat bzw. die Baugruppe einer Behandlung zur Verringerung der Lebensdauer der Ladungsträger, wie beispielsweise einer Bestrahlung oder einer Diffusion von Fremdmetallverunreinigungen, unterzogen wurde.

## Claims

1. A monolithic assembly in an N-type substrate (1) of a vertical fast diode aimed at operating in a forward direction with at least one additional vertical component separated from the diode by an isolation wall (8), wherein the fast diode is of the Schottky-bipolar-type and is formed between a first metallization in one surface of the substrate in contact with the substrate and wire a P⁺-type discontinuous region (6, 15) and a second metallization on the second surface of the substrate in contact with an N⁺-type continuous region (5, 14), one of the first and second metallization extending on a whole surface of the substrate and also constituting a metallization of said at least one additional vertical component.

2. The monolithic assembly of claim 1, characterized in that, when the P⁺-type discontinuous region of the fast diode is at the bottom surface of the assembly, said fast diode is surrounded with an isolation wall (8).

3. The monolithic assembly of claim 1, characterized in that the other vertical component is a junction diode.

4. The monolithic assembly of claim 1, characterized in that the other vertical component is a diode of the same type as the first diode but with different characteristics.

5. The monolithic assembly of claim 4, characterized in that the discontinuous P⁺-type regions (6, 15) of the two diodes have different proportions.

6. The monolithic assembly of any of claims 1 to 5, characterized in that the monolithic assembly results from a carrier lifetime reduction process, such as radiation or diffusion of metal impurities.
